# EUROPEAN PATENT APPLICATION

(11) **EP 2 025 695 A1**
(43) Date of publication of application: **18.02.2009**
(21) Application number: 07744791.0
(22) Date of filing: 06.06.2007
(51) Int. Cl.: C08G 59/24

(54) **EPOXY RESIN COMPOSITION AND CURED EPOXY RESIN**

(30) Priority: 07.06.2006 JP 2006158154
(71) Applicant: Sumitomo Chemical Company, Limited, Tokyo 104-8260 (JP); Hitachi Ltd. and Hitachi-LG Data Storage, Inc., Tokyo 100-8280 (JP)
(72) Inventor: TANAKA, Shinya, Toyono-gun, Osaka 563-0103 (JP); TAKEZAWA, Yoshitaka, Hitachi-shi, Ibaraki 319-1292 (JP); FUKUSHIMA, Keiji, Hitachi-shi, Ibaraki 319-1292 (JP)
(74) Representative: Vossius & Partner
(86) International application number: PCT/JP2007/061448
(87) International publication number: WO 2007/142262

(57) **Abstract**

An epoxy resin composition comprising an epoxy compound represented by the formula (1): 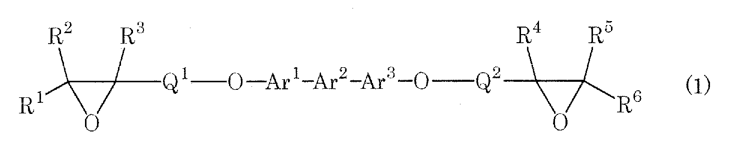 wherein Ar¹, Ar² and Ar³ each denotes any one of divalent groups represented by the following formulas: 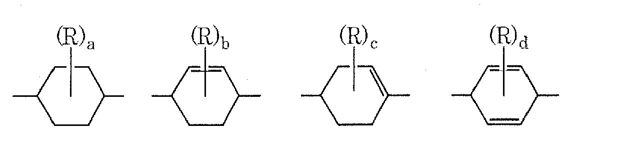 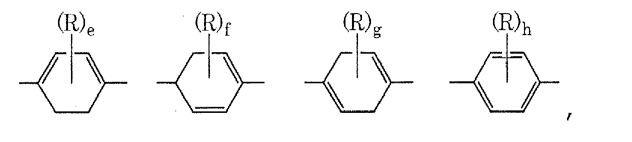 a curing agent and an alumina powder, wherein the alumina powder is a mixture of an alumina (A) having D50 of 2 µm or more and 100 µm or less, an alumina (B) having D50 of 1 µm or more and 10 µm or less, and an alumina (C) having D50 of 0.01 µm or more and 5 µm or less, in which D50 is a particle size at 50% cumulation from the smallest particle side of a weight cumulative particle size distribution, and the content of the alumina (A), that of the alumina (B) and that of the alumina (C) are respectively 50% by volume or more and 90% by volume or less, 5% by volume or more and 40% by volume or less, and 1% by volume or more and 30% by volume or less, based on the volume of the alumina powder (provided that the total % by volume of the alumina (A), the alumina (B) and the alumina (C) is 100% by volume).

## Description

### Technical Field

This application claims priority under the Paris Convention on Japanese Patent Application No. 2006-158154 filed on June 7, 2006, titled "EPOXY ERSAZT COMPOSITE MATERIAL", the entire disclosure of which is incorporated by reference herein.
The present invention relates to an epoxy resin composition and a cured epoxy resin.

### Background Art

Japanese Unexamined Patent Publication (Kokai) No. 10-237311 and Japanese Unexamined Patent Publication (Kokai) No. 2005-206814 disclose an epoxy resin composition containing an alumina powder.

### Disclosure of the Invention

The present invention provides:
<1> an epoxy resin composition comprising an epoxy compound represented by the formula (1): 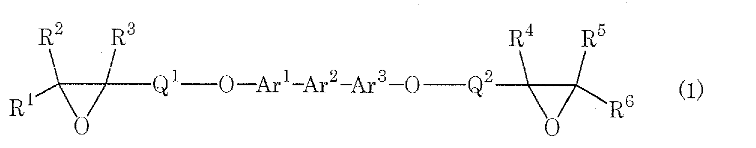 wherein Ar¹, Ar² and Ar³ are the same or different and each denotes any one of divalent groups represented by the following formulas: 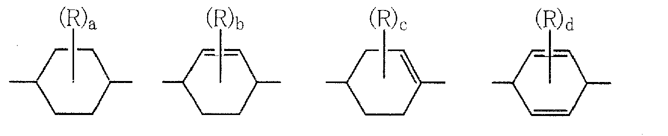 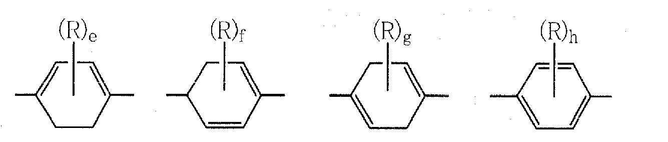 in which R denotes hydrogen atom or an alkyl group having 1 to 18 carbon atoms, a denotes an integer of 1 to 8, b, e and g denote an integer of 1 to 6, c denotes an integer of 1 to 7, d and h denote an integer of 1 to 4, f denotes an integer of 1 to 5, and when more than one R exists in said divalent group, all of R may be the same group or different groups; R¹, R², R³, R⁴, R⁵ and R⁶ are the same or different and each denotes hydrogen atom or an alkyl group having 1 to 18 carbon atoms; Q¹ and Q² are the same or different and each denotes a straight-chain alkylene group having 1 to 9 carbon atoms, in which methylene group composing the straight-chain alkylene group is optionally substituted with an alkyl group having 1 to 18 carbon atoms and -O- or -N(R⁷)- is optionally inserted between the methylene groups, in which R⁷ denotes hydrogen atom or an alkyl group having 1 to 18 carbon atoms; a curing agent and an alumina powder, wherein
   the alumina powder is a mixture of:
   an alumina (A) having D50 of 2 µm or more and 100 µm or less,
   an alumina (B) having D50 of 1 µm or more and 10 µm or less, and
   an alumina (C) having D50 of 0.01 µm or more and 5 µm or less, in which D50 is a particle size at 50% cumulation from the smallest particle side of a weight cumulative particle size distribution, and
   the content of the alumina (A), that of the alumina (B) and that of the alumina (C) are respectively 50% by volume or more and 90% by volume or less, 5% by volume or more and 40% by volume or less, and 1% by volume or more and 30% by volume or less, based on the volume of the alumina powder (provided that the total % by volume of the alumina (A), the alumina (B) and the alumina (C) is 100% by volume);

<2> the epoxy resin composition according to <1>, wherein the alumina powder is an α-alumina powder;

<3> the epoxy resin composition according to <1> or <2>, wherein the epoxy compound represented by the formula (1) is an epoxy compound represented by the formula (2): 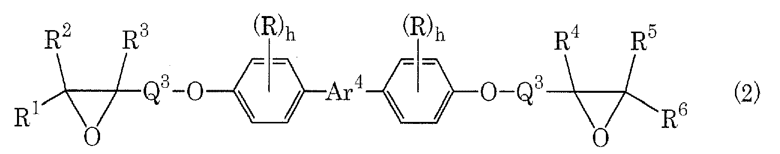 wherein Ar⁴ denotes any one of divalent groups represented by the following formulas: 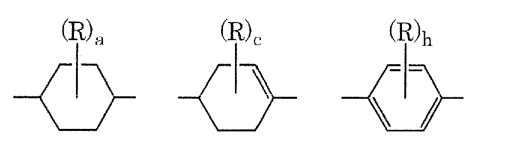 R, R¹, R², R³, R⁴, R⁵, R⁶, a, c and h are as defined above; Q³ denotes any one of groups represented by the following formulas:

   -(CH₂)ₘ- -(CH₂)ₚ-O-(CH₂)_{q}-

   m denotes an integer of 1 to 9; p and q each denotes an integer of 1 to 8 and the sum of p and q is 9 or less, in which methylene group composing the group denoted by Q₃ is optionally substituted with an alkyl group having 1 to 18 carbon atoms;

<4> the epoxy resin composition according to <3>, wherein R¹, R², R³, R⁴, R⁵ and R⁶ in the formula (2) denote hydrogen atom;

<5> the epoxy resin composition according to <3>, wherein the epoxy compound represented by the formula (2) is an epoxy compound represented by the formula (3): 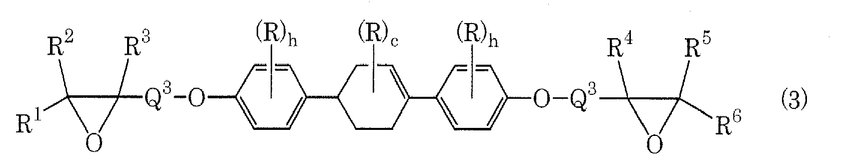 wherein R, R¹, R², R³, R⁴, R⁵, R⁶, a, c and h are as defined above; Q³ denotes a group represented by the following formula:

   -(CH₂)ₘ-

   and m denotes an integer of 1 to 9;

<6> the epoxy resin composition according to <5>, wherein R¹, R², R³, R⁵, R⁵ and R⁶ in the formula (3) denote hydrogen atom;

<7> the epoxy resin composition according to <5>, wherein the epoxy compound represented by the formula (3) is an epoxy compound represented by the formula (4): 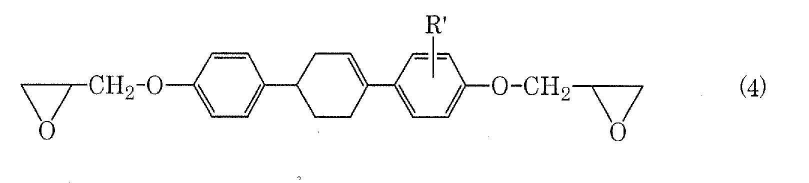 wherein R' denotes hydrogen atom or an alkyl group having 1 to 4 carbon atoms;

<8> the epoxy resin composition according to any one of <1> to <7>, wherein the curing agent is an amine type curing agent, a resorcin novolak type curing agent, a phenol novolak type curing agent or an acid anhydride type curing agent;

<9> the epoxy resin composition according to any one of <1> to <7>, wherein the curing agent is an amine type curing agent;

<10> the epoxy resin composition according to <9>, wherein the amine type curing agent is 4,4'-diaminodiphenylmethane, 4,4'-diaminodiphenylethane, 1,5-diaminonaphthalene or p-phenylenediamine;

<11> the epoxy resin composition according to any one of <1> to <10>, further containing an inorganic fiber which contains alumina as a main component and has a number-average fiber diameter of 1 to 50 µm; and

<12> a cured epoxy resin obtained by curing the epoxy resin composition according to any one of <1> to <11>.

### Best Mode for Carrying Out the Invention

In the epoxy compound represented by the formula (1) (hereinafter abbreviated to an epoxy compound (1)), R denotes hydrogen atom or an alkyl group having 1 to 18 carbon atoms.
Examples of the alkyl group having 1 to 18 carbon atoms include straight-chain or branched chain alkyl groups having 1 to 18 carbon atoms such as methyl, ethyl, n-propyl, isopropyl, n-butyl, isobutyl, sec-butyl, tert-butyl, n-pentyl, n-hexyl, n-octyl, isooctyl, n-decyl, n-dodecyl, n-pentadecyl and n-octadecyl group. Preferred is an alkyl group having 1 to 10 carbon atoms, more preferred is an alkyl group having 1 to 6 carbon atoms, still more preferred is an alkyl group having 1 to 4 carbon atoms, and particularly preferred is a methyl group.

As the divalent group, any one of divalent groups represented by the following formulas: 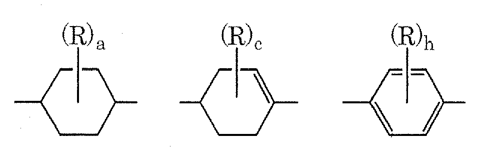 is preferred.

Specific examples of the divalent group include cyclohexane-1,4-diyl, 2-cyclohexene-1,4-diyl, 1-cyclohexene-1,4-diyl, 1,4-cyclohexadiene-3,6-diyl, 1,3-cyclohexadiene-1,4-diyl, 1,3-cyclohexanediene-2,5-diyl, 1,4-cyclohexanediene-1,4-diyl, 1,4-phenylene, 2-methylcyclohexane-1,4-diyl and 3-methyl-1, 4-phenylene group. Among these divalent groups, cyclohexane-1,4-diyl, 1-cyclohexene-1,4-diyl, 1,4-phenylene, 2-methylcyclohexane-1,4-diyl, 3-methyl-1,4-phenylene, 2-methyl-1,4-phenylene, 3-ethyl-1,4-phenylene, 2-ethyl-1,4-phenylene, 3-n-propyl-1,4-phenylene and 3-isopropyl-1,4-phenylene group are preferred.
R¹, R², R³, R⁴, R⁵ and R⁶ are the same or different and each denotes hydrogen atom or an alkyl group having 1 to 18 carbon atoms. Examples of the alkyl group having 1 to 18 carbon atoms include the same groups as those described above.

Q¹ and Q² are the same or different and each denotes a straight-chain alkylene group having 1 to 9 carbon atoms. Examples of the straight-chain alkylene group having 1 to 9 carbon atoms include groups formed by bonding 1 to 9 methylene groups linearly, such as methylene, ethylene, trimethylene, tetramethylene, hexamethylene and nonamethylene group. Preferred is a straight-chain alkylene group having 1 to 4 carbon atoms, and more preferred is a methylene group. A methylene group or groups composing such a straight-chain alkylene group having 1 to 9 carbon atoms is optionally substituted with an alkyl group or groups having 1 to 18 carbon atoms, and -O- or -N(R⁷)- is optionally inserted between the methylene groups. Examples of the alkylene group in which methylene group or groups are substituted with an alkyl group or groups having 1 to 8 carbon atoms or in which -O- or -N(R⁷)- is inserted between the methylene groups include 2-methyltrimethylene, 1,2-dimethylethylene, 3-oxatetramethylene and 3-oxapentamethylene group. Among these alkylene groups, preferred is 3-oxapentamethylene group.

Among the epoxy compound (1), preferred is an epoxy compound represented by the formula (2): 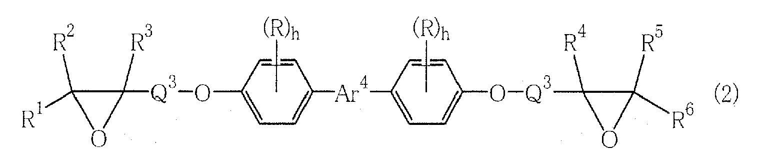 wherein Ar⁴ denotes any one of divalent groups represented by the following formulas: 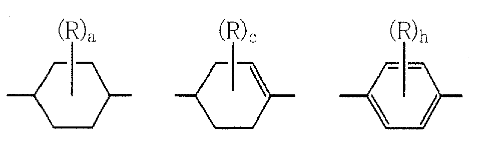 R, R¹, R², R³, R⁴, R⁵, R⁶, a, c and h are as defined above; Q³ denotes any one of groups represented by the following formulas:

-(CH₂)ₘ-

-(CH₂)ₚ-O-(CH₂)_{q}-

m denotes an integer of 1 to 9; p and q each denotes an integer of 1 to 8 and the sum of p and q is 9 or less, in which methylene group composing the group denoted by Q³ is optionally substituted with an alkyl group having 1 to 18 carbon atoms, and more preferred is an epoxy compound wherein R¹, R², R³, R⁴, R⁵ and R⁶ denote hydrogen atom.

Furthermore, more preferred is an epoxy compound wherein Q³ denotes a group represented by the following formula:

-(CH₂)ₘ-

still more preferred is an epoxy compound wherein m denotes 1 to 4, and particularly preferred is a compound wherein m denotes 1.

Also, preferred is an epoxy compound represented by the formula (4): 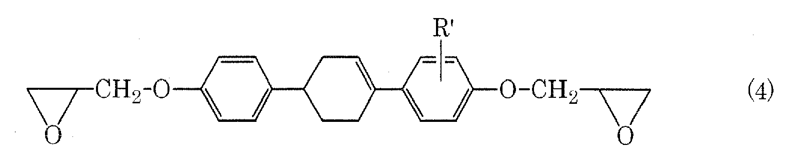 wherein R' denotes hydrogen atom or an alkyl group having 1 to 4 carbon atoms.

Examples of the epoxy compound (1) include
1,4-bis{4-(oxiranylmethoxy)phenyl}-1-cyclohexene,
1-{3-methyl-4-(oxiranylmethoxy)phenyl}-4-{4-(oxiranylmethoxy) phenyl}-1-cyclohexene,
1-{2-methyl-4-(oxiranylmethoxy)phenyl}-4-{4-(oxiranylmethoxy) phenyl}-1-cyclohexene,
1-{3-ethyl-4-(oxiranylmethoxy)phenyl}-4-{4-(oxiranylmethoxy)p henyl}-1-cyclohexene,
1-{2-ethyl-4-(oxiranylmethoxy)phenyl}-4-{4-(oxiranylmethoxy)p henyl}-1-cyclohexene,
1-{3-n-propyl-4-(oxiranylmethoxy)phenyl}-4-{4-(oxiranylmethox y)phenyl}-1-cyclohexene,
1-{3-isopropyl-4-(oxiranylmethoxy)phenyl}-4-{4-(oxiranylmetho xy)phenyl}-1-cyclohexene,
1,4-bis{4-(oxiranylmethoxy)phenyl}-2-cyclohexene,
1-{3-methyl-4-(oxiranylmethoxy)phenyl}-4-{4-(oxiranylmethoxy) phenyl}-2-cyclohexene,
1,4-bis{4-(oxiranylmethoxy)phenyl}-2,5-cyclohexadiene,
1-{3-methyl-4-(oxiranylmethoxy)phenyl}-4-{4-(oxiranylmethoxy) phenyl}-2,5-cyclohexadiene,
1,4-bis{4-(oxiranylmethoxy)phenyl}-1,5-cyclohexadiene,
1-{3-methyl-4-(oxiranylmethoxy)phenyl}-4-{4-(oxiranylmethoxy) phenyl}-1,5-cyclohexadiene,
1,4-bis{4-(oxiranylmethoxy)phenyl}-1,4-cyclohexadiene,
1-{3-methyl-4-(oxiranylmethoxy)phenyl}-4-{4-(oxiranylmethoxy) phenyl}-1,4-cyclohexadiene,
1,4-bis{4-(oxiranylmethoxy)phenyl}-1,3-cyclohexadiene,
1-{3-methyl-4-(oxiranylmethoxy)phenyl}-4-{4-(oxiranylmethoxy) phenyl}-1,3-cyclohexadiene,
1,4-bis{4-(oxiranylmethoxy)phenyl}benzene,
1-{3-methyl-4-(oxiranylmethoxy)phenyl}-4-{4-(oxiranylmethoxy) phenyl}benzene,

1,4-bis{4-(oxiranylmethoxy)phenyl}cyclohexane,
1-{3-methyl-4-(oxiranylmethoxy)phenyl}-4-{4-(oxiranylmethoxy) phenyl}cyclohexane,
1,4-bis{4-(3-oxa-5,6-epoxyhexyloxy)phenyl}-1-cyclohexene,
1-{4-(3-oxa-5,6-epoxyhexyloxy)-3-methylphenyl}-4-{4-(3-oxa-5, 6-epoxyhexyloxy)phenyl}-1-cyclohexene,
1,4-bis{4-(5-methyl-3-oxa-5,6-epoxyhexyloxy)phenyl}-1-cyclohe xene,
1-{4-(5-methyl-3-oxa-5,6-epoxyhexyloxy)-3-methylphenyl}-4-{4-(5-methyl-3-oxa-5,6-epoxyhexyloxy)phenyl}-1-cyclohexene,
1,4-bis{4-(4-methyl-4,5-epoxypentyloxy)phenyl}-1-cyclohexene, 1,4-bis{4-(3-oxa-5,6-epoxyhexyloxy)phenyl}benzene,
1-{4-(3-oxa-5,6-epoxyhexyloxy)-3-methylphenyl}-4-{4-(3-oxa-5, 6-epoxyhexyloxy)phenyl}benzene,
1,4-bis{4-(5-methyl-3-oxa-5,6-epoxyhexyloxy)phenyl}benzene,
1-{4-(5-methyl-oxa-5,6-epoxyhexyloxy)-3-methylphenyl}-4-{4-(5 -methyl-3-oxa-5,6-epoxyhexyloxy)phenyl}benzene,
1,4-bis{4-(4-methyl-4,5-epoxypentyloxy)phenyl}benzene,
1,4-bis{4-(3-oxa-5,6-epoxyhexyloxy)phenyl}cyclohexane,
1-{4-(3-oxa-5,6-epoxyhexyloxy)-3-methylphenyl}-4-{4-(3-oxa-5, 6-epoxyhexyloxy)phenyl}cyclohexane,
1,4-bis{4-(5-methyl-3-oxa-5,6-epoxyhexyloxy)phenyl}cyclohexan e,
1-{4-(5-methyl-3-oxa-5,6-epoxyhexyloxy)-3-methylphenyl}-4-{4-(5-methyl-3-oxa-5,6-epoxyhexyloxy)phenyl}cyclohexane and
1,4-bis{4-(4-methyl-4,5-epoxypentyloxy)phenyl}cyclohexane.

Among these epoxy compounds,
1,4-bis{4-(oxiranylmethoxy)phenyl}-1-cyclohexene,
1-{3-methyl-4-(oxiranylmethoxy)phenyl}-4-{4-(oxiranylmethoxy) phenyl}-1-cyclohexene,
1-{2-methyl-4-(oxiranylmethoxy)phenyl}-4-{4-(oxiranylmethoxy) phenyl}-1-cyclohexene,
1-{3-ethyl-4-(oxiranylmethoxy)phenyl}-4-{4-(oxiranylmethoxy)p henyl}-1-cyclohexene,
1-{2-ethyl-4-(oxiranylmethoxy)phenyl}-4-{4-(oxiranylmethoxy)p henyl}-1-cyclohexene,
1-{3-n-propyl-4-(oxiranylmethoxy)phenyl}-4-{4-(oxiranylmethox y)phenyl}-1-cyclohexene,
1-{3-isopropyl-4-(oxiranylmethoxy)phenyl}-4-{4-(oxiranylmetho xy)phenyl}-1-cyclohexene,
1,4-bis{4-(oxiranylmethoxy)phenyl}benzene,
1-{3-methyl-4-(oxiranylmethoxy)phenyl}-4-{4-(oxiranylmethoxy) phenyl}benzene,
1,4-bis{4-(oxiranylmethoxy)phenyl}cyclohexane,
1-{3-methyl-4-(oxiranylmethoxy)phenyl}-4-{4-(oxiranylmethoxy) phenyl}cyclohexane,
1,4-bis{4-(3-oxa-5,6-epoxyhexyloxy)phenyl}-1-cyclohexene,
1-{4-(3-oxa-5,6-epoxyhexyloxy)-3-methylphenyl}-4-{4-(3-oxa-5, 6-epoxyhexyloxyphenyl}-1-cyclohexene,
1,4-bis{4-(3-oxa-5,6-epoxyhexyloxy)phenyl}benzene,
1-{4-(3-oxa-5,6-epoxyhexyloxy)-3-methylphenyl}-4-{4-(3-oxa-5, 6-epoxyhexyloxy)phenyl}benzene,
1,4-bis{4-(3-oxa-5,6-epoxyhexyloxy)phenyl}cyclohexane and
1-{4-(3-oxa-5,6-epoxyhexyloxy)-3-methylphenyl}-4-{4-(3-oxa-5,
6-epoxyhexyloxy)phenyl}cyclohexane are preferred.

Among these epoxy compounds,
1,4-bis{4-(oxiranylmethoxy)phenyl}-1-cyclohexene,
1-{3-methyl-4-(oxiranylmethoxy)phenyl}-4-{4-(ox-ranylmethoxy) phenyl}-1-cyclohexene,
1-{2-methyl-4-(oxiranylmethoxy)phenyl}-4-{4-(oxiranylmethoxy) phenyl}-1-cyclohexene,
1-{3-ethyl-4-(oxiranylmethoxy)phenyl}-4₋{4-(oxiranylmethoxy)p henyl}-1-cyclohexene,
1-{2-ethyl-4-(oxiranylmethoxy)phenyl}-4-{4-(oxiranylmethoxy)p henyl}-1-cyclohexene,
1-{3-n-propyl-4-(oxiranylmethoxy)phenyl}-4-{4-(oxiranylmethox y)phenyl}-1-cyclohexene,
1-{3-isopropyl-4-(oxiranylmethoxy)phenyl}-4-{4-(oxiranylmetho xy)phenyl}-1-cyclohexene,
1,4-bis{4-(oxiranylmethoxy)phenyl}benzene,
1-{3-methyl-4-(oxiranylmethoxy)phenyl}-4-{4-(oxiranylmethoxy) phenyl}benzene,
1,4-bis{4-(oxiranylmethoxy)phenyl}cyclohexane and
1-{3-methyl-4-(oxiranylmethoxy)phenyl}-4-{4-(oxiranylmethoxy) phenyl}cyclohexane are more preferred.

Among these epoxy compounds,
1,4-bis{4-(oxiranylmethoxy)phenyl}-1-cyclohexene,
1-{3-methyl-4-(oxiranylmethoxy)phenyl}-4-{4-(oxiranylmethoxy) phenyl}-1-cyclohexene,
1-{2-methyl-4-(oxiranylmethoxy)phenyl}-4-{4-(oxiranylmethoxy) phenyl}-1-cyclohexene,
1-{3-ethyl-4-(oxiranylmethoxy)phenyl}-4-{4-(oxiranylmethoxy)p henyl}-1-cyclohexene,
1-{2-ethyl-4-(oxiranylmethoxy)phenyl}-4-{4-(oxiranylmethoxy)p henyl}-1-cyclohexene,
1-{3-n-propyl-4-(oxirarylmethoxy)phenyl}-4-{4-(oxiranylmethox y)phenyl}-1-cyclohexene and
1-{3-isopropyl-4-(oxiranylmethoxy)phenyl}-4-{4-(oxiranylmetho xy)phenyl}-1-cyclohexene are still more preferred.

The epoxy compound (1) can be produced, for example, by the method described in Japanese Unexamined Patent Publication (Kokai) No. 2005-206814.

The epoxy resin composition of the present invention contains an alumina powder and the alumina powder is a mixture of:
an alumina (A) having D50 of 2 µm or more and 100 µm or less,
an alumina (B) having D50 of 1 µm or more and 10 µm or less, and
an alumina (C) having D50 of 0.01 µm or more and 5 µm or less, in which D50 is a particle size at 50% cumulation from the smallest particle side of a weight cumulative particle size distribution, and
the content of the alumina (A), that of the alumina (B) and that of the alumina (C) are respectively 50% by volume or more and 90% by volume or less, 5% by volume or more and 40% by volume or less, and 1% by volume or more and 30% by volume or less, based on the volume of the alumina powder (provided that the total % by volume of the alumina (A), the alumina (B) and the alumina (C) is 100% by volume).

As the alumina powder, preferred is an alumina powder
wherein the content of the alumina (A), that of the alumina (B) and that of the alumina (C) are respectively 60% by volume or more and 90% by volume or less, 10% by volume or more and 40% by volume or less, and 5% by volume or more and 30% by volume or less, based on the volume of the alumina powder (provided that the total % by volume of the alumina (A), the alumina (B) and the alumina (C) is 100% by volume), and more preferred is an alumina powder wherein the content of the alumina (A), that of the alumina (B) and that of the alumina (C) are respectively 70% by volume or more and 90% by volume or less, 10% by volume or more and 30% by volume or less, and 5% by volume or more and 20% by volume or less, based on the volume of the alumina powder (provided that the total % by volume of the alumina (A), the alumina (B) and the alumina (C) is 100% by volume).

As the alumina (A), the alumina (B) and the alumina (C), commercially available alumina may be used, and can be produced by firing a transition alumina or an alumina powder, which is converted into a transition alumina by a heat treatment, in an atmospheric gas containing hydrogen chloride (for example, refer to Japanese Unexamined Patent Publication (Kokai) No. 6-191833 and Japanese Unexamined Patent Publication (Kokai) No. 191836). The alumina powder can be prepared by appropriately mixing the alumina (A), the alumina (B) and the alumina (C).

The alumina powder is preferably α-alumina powder.
The alumina (A) or alumina (B) is preferably alumina composed of α-alumina particles, and more preferably alumina composed of α-alumina single crystal particles. The alumina (C) may be alumina composed of α-alumina particles or alumina composed of transition alumina particles, such as γ-alumina, θ-alumina, 5-alumina. Among these alumina, preferred is alumina composed of α-alumina particles, and more preferred is alumina composed of α-alumina single crystal particles.

The used amount of the alumina powder is decided so that the volume of the alumina powder is usually from 30 to 95%, and preferably from 60 to 95%, based on the total volume of the epoxy compound (1), the curing agent and the alumina powder. When the volume of the alumina powder is less than 30% based on the total volume of the epoxy compound (1), the curing agent and the alumina powder, sufficient effect of enhancing thermal conductivity of the epoxy resin composition is not exerted. In contrast, when the volume of the alumina powder is more than 95%, moldability of the epoxy resin composition tends to deteriorate.

The epoxy resin composition of the present invention may also contain, in addition to the alumina powder, an inorganic fiber containing alumina as a main component and having a number-average fiber diameter of 1 to 50 µm. In the present invention, the "inorganic fiber containing alumina as a main component" means an inorganic fiber containing 50% by weight or more of alumina. Among the inorganic fiber, preferred is an inorganic fiber containing 70% by weight or more of alumina, and more preferred is an inorganic fiber containing 90% by weight or more of alumina. The number-average fiber diameter of the inorganic fiber is from 1 to 50 µm, preferably from 1 to 30 µm, and more preferably from 1 to 20 µm. The fiber length of the inorganic fiber is usually from 0.1 to 100 mm.

As the inorganic fiber, commercially available inorganic fibers are usually used and specific examples thereof include Alutex (manufactured by Sumitomo Chemical Co., Ltd.), Denka-arusen (manufactured by Electrochemical Industries Company) and MAFTEC Bulk Fiber (manufactured by Mitsubishi Plastics, Inc.).

The used amount of the inorganic fiber is usually from 5 to 70% by volume, and preferably from 5 to 50%, based on the volume of the alumina powder, and the total volume of the alumina powder and the inorganic fiber is usually from 30 to 95% based on the total volume of the epoxy compound (1), the curing agent and the alumina powder.

The curing agent may have at least two functional groups capable of causing a curing reaction with an epoxy group in the molecule and examples thereof include an amine type curing agent having amino groups as functional groups, a phenol type curing agent having hydroxyl groups as functional groups, and an acid anhydride type curing agent having carboxyl groups as functional groups. Among these curing agents, preferred is an amine type curing agent or a phenol type curing agent, and more preferred is an amine type curing agent.

Examples of the amine type curing agent include aliphatic polyvalent amines having 2 to 20 carbon atoms such as ethylenediamine, trimethylenediamine, tetramethylenediamine, hexamethylenediamine, diethylenetriamine and triethylenetetramine; aromatic polyvalent amines such as p-xylenediamine, m-xylenediamine, 1,5-diaminonaphthalene, m-phenylenediamine, p-phenylenediamine, 4,4'-diaminodiphenylmethane, 4,4'-diaminodiphenylethane, 4,4'-diaminodiphenylpropane, 4,4'-diaminodiphenylether, 1,1-bis(4-aminophenyl)cyclohexane, 4,4'-diaminodiphenylsulfone and bis(4-aminophenyl)phenylmethane; alicyclic polyvalent amines such as 4,4'-diaminodicyclohexane and 1,3-bis(aminomethyl)cyclohexane; and dicyandiamide. Among these amine type curing agents, aromatic polyvalent amines are preferred, and 4,4'-diaminodiphenylmethane, 4,4'-diaminodiphenylethane, 1,5-diaminonaphthalene and p-phenylenediamine are more preferred.

Examples of the phenol type curing agent include phenol resin, phenol aralkyl resin (having a phenylene framework, diphenylene framework, etc.), naphthol aralkyl resin and polyoxystyrene resin. Examples of the phenol resin include resol type phenol resins such as aniline-modified resol resin and dimethyl ether resol resin; novolak type phenol resins such as phenol novolak resin, cresol novolak resin, tert-butyl phenol novolak resin and nonyl phenol novolak resin; special phenol resins such as dicyclopentadiene-modified phenol resin, terpene-modified phenol resin and triphenol methane type resin. Examples of the poloxystyrene resin include poly(p-oxystyrene)

Examples of the acid anhydride type curing agent include maleic anhydride, phthalic anhydride, pyromellitic anhydride and trimellitic anhydride.

The used amount of the curing agent is decided so that the total amount of functional groups capable of causing a curing reaction with an epoxy resin in the curing agent is usually 0.5 to 1.5 times, and preferably from 0.9 to 1.1 times, larger than that of epoxy groups in the epoxy compound (1).

The epoxy resin composition of the present invention may contain, in addition to the epoxy compound (1), the curing agent and alumina, another epoxy compound and various additives as long as desired performances of the cured epoxy resin obtained by curing the epoxy resin composition are not adversely affected.

Examples of another epoxy compound include bisphenol A type epoxy compound, ortho-cresol type epoxy compound, biphenol diglycidyl ether, 4,4'-bis(3,4-epoxybuten-1-yloxy)phenyl benzoate, naphthalene diglycidyl ether and α-methylstilbene-4,4'-diglycidyl ether.

Examples of the additive include silica powders such as fused crushed silica, fused spherical silica powder, crystal silica powder and secondary cohesive silica; fillers such as titanium white, aluminum hydroxide, talc, clay, mica and glass fiber; curing accelerators such as triphenylphosphine, 1,8-azabicyclo[5.4.0]-7-undecene and 2-methylimidazole; coupling agents such as γ-glycidoxypropyltrimethoxysilane; colorants such as carbon black; low-stress components such as silicone oil and silicone rubber; mold release agents such as natural wax, synthetic wax, higher fatty acid or metal salt thereof, and paraffin; and antioxidants. The content of another epoxy compound and additives mentioned above may be the content which does not adversely affect desired performances of the cured epoxy resin obtained by curing the epoxy resin composition of the present invention.

The epoxy resin composition of the present invention may contain a solvent and the solvent is not particularly limited as long as it does not inhibit the curing reaction of the epoxy resin composition.

The cured epoxy resin can be produced by curing the epoxy resin composition of the present invention. The resultant cured epoxy resin exhibits high thermal conductivity and is therefore useful as insulating materials of printed circuit boards to which high heat dissipation properties require.

Examples of the method of producing the cured epoxy resin include a method of curing an epoxy resin composition by heating to a predetermine temperature; a method of melting an epoxy resin composition with heating, injecting the melt into a mold and heating the mold, followed by molding; a method of melting an epoxy resin composition, injecting the resultant melt in a mold and curing the melt; a method of filling a mold with a powder, which is obtained by partially curing an epoxy resin composition and grinding the resultant partially cured epoxy resin composition, and melt-molding the filled powder; and a method of optionally dissolving an epoxy resin composition in a solvent, partially curing with stirring, casting the resultant solution, removing the solvent through forced-air drying and optionally heating for a predetermined time while applying a pressure using a press.

Also, a prepreg can be produced by optionally diluting an epoxy resin composition of the present invention with a solvent, coating or impregnating a base material with the epoxy resin composition and semi-curing the coated or impregnated base material with heating. Examples of the base material include woven or nonwoven fabric made of an inorganic fiber, such as glass fiber woven fabric; and woven or nonwoven fabric made of an organic fiber such as polyester fiber. Using the prepreg, a laminate can be easily produced by a conventional method.

### Examples

Hereinafter, the present invention is further illustrated in detail by referring to Examples, but the present invention is not limited to Examples.

### Example 1

100 parts by weight of 1-(3-methyl-4-oxiranylmethoxyphenyl)-4-(4-oxiranylmethoxyphen yl)-1-cyclohexene, 20 parts by weight of 1,5-diaminonaphthalene (manufactured by Wako Pure Chemical Industries, Ltd.), 1,107 parts by weight of an alumina powder (α-alumina powder manufactured by Sumitomo Chemical Co., Ltd.; a mixture of 819 parts by weight of alumina having D50 of 18 µm (74% by volume based on the alumina powder), 155 parts by weight of alumina having D50 of 3 µm (14% by volume based on the alumina powder) and 133 parts by weight of alumina having D50 of 0.4 µm (12% by volume based on the alumina powder)) and 300 parts by weight of methyl ethyl ketone were mixed and the resultant mixture was deaerated under vacuum conditions to obtain an epoxy resin composition. The content of the alumina powder based on the total volume of 1-(3-methyl-4-oxiranylmethoxyphenyl)-4-(4-oxiranylmethoxyphen yl)-1-cyclohexene, 1,5-diaminonaphthalene and the alumina powder was calculated assuming that a density of a mixture of 1-(3-methyl-4-oxiranylmethoxypuenyl)-4-(4-oxiranylmethoxyphen yl)-1-cyclohexene and 1,5-diaminonaphthalene is 1.2 g/cm² and a density of the alumina powder is 3.97 g/cm³. As a result, it was 74% by volume.

Using an applicator, the epoxy resin composition was applied on a polyethylene terephthalate base material in a thickness of 400 µm and then dried by standing at room temperature for one hour. After further drying at a temperature of 60°C under a vacuum degree of 1 kPa for 1 0 minutes, vacuum press molding (press temperature: 140°C, vacuum degree: 1 kPa, press pressure: 2 MPa, treating time: 3.5 minutes) was performed to obtain a prepreg sheet.
After peeling the polyethylene terephthalate film of both surfaces of the resultant prepreg sheet, both surfaces were sandwiched with a copper foil (35 µm) and vacuum-bonded (temperature: 140°C, vacuum degree: 1 kPa, press pressure: 4 MPa, treating time: 10 minutes). Under atmospheric pressure conditions, heating was performed at 140°C for 2 hours, then at 180°C for 3 hours. The resultant sheet was cut into pieces measuring 10 mm × 10 mm and the copper foil was removed to obtain a 200 µm thick resin sheet. Thermal conductivity of the resultant resin sheet was measured by a xenon flash method, a laser flash method and a temperature wave thermal analytical method. As a result, thermal conductivity measured by the xenon flash method was 9.4 W/m·K and thermal conductivity measured by the temperature wave thermal analytical method was 10.4 W/m·K, while thermal conductivity could not be measured by the laser flash method.

### Example 2

100 parts by weight of 1-(3-methyl-4-oxiranylmethoxyphenyl)-4-(4-oxiranylmethoxyphen yl)-1-cyclohexene, 20 parts by weight of 1, 5-diaminonaphthalene (manufactured by Wako Pure Chemical Industries, Ltd.), 364 parts by weight of an alumina powder (α-alumina powder manufactured by Sumitomo Chemical Co., Ltd.; a mixture of 238 parts by weight of alumina having D50 of 18 µm (65% by volume based on the alumina powder), 68 parts by weight of alumina having D50 of 3 µm (19% by volume based on the alumina powder) and 58 parts by weight of alumina having D50 of 0.4 µm (16% by volume based on the alumina powder)), 121 parts by weight of an alumina fiber (number-average fiber diameter: 5 µm) and 300 parts by weight of methyl ethyl ketone were mixed and the resultant mixture was deaerated under vacuum conditions to obtain an epoxy resin composition. The content of the alumina powder and the alumina fiber based on the total volume of 1-(3-methyl-4-oxiranylmethoxyphenyl)-4-(4-oxiranylmethoxyphen yl)-1-cyclohexene, 1,5-diaminonaphthalene, the alumina powder and the alumina fiber was calculated assuming that a density of a mixture of 1-(3-methyl-4-oxiranylmethoxyphenyl)-4-(4-oxiranylmethoxyphen yl)-1-cyclohexene and 1,5-diaminonaphthalene is 1.2 g/cm³ and a density of the alumina powder and the alumina fiber is 3.97 g/cm³. As a result, it was 55% by volume.

Using an applicator, the epoxy resin composition was applied on a polyethylene terephthalate base material in a thickness of 400 µm and then dried by standing at room temperature for one hour. After further drying at a temperature of 60°C under a vacuum degree of 1 kPa for 10 minutes, vacuum press molding (press temperature: 140°C, vacuum degree: 1 kPa, press pressure: 2 MPa, treating time: 3.5 minutes) was performed to obtain a prepreg sheet.
After peeling the polyethylene terephthalate film of both surfaces of the resultant prepreg sheet, both surfaces were sandwiched with a copper foil (35 µm) and vacuum-bonded (temperature: 140°C, vacuum degree: 1 kPa, press pressure: 4 MPa, treating time: 10 minutes). Under atmospheric pressure conditions, heating was performed at 140°C for 2 hours, then at 180°C for 3 hours. The resultant sheet was cut into pieces measuring 10 mm × 10 mm and the copper foil was removed to obtain a 200 µm thick resin sheet. Thermal conductivity of the resultant resin sheet was measured by a xenon flash method, a laser flash method and a temperature wave thermal analytical method. As a result, thermal conductivity measured by the xenon flash method was 4.9 W/m·K and thermal conductivity measured by the temperature wave thermal analytical method was 5.4 (W/m·K, while thermal conductivity could not be measured by the laser flash method.

### Example 3

100 parts by weight of 1-(3-methyl-4-oxiranylmethoxyphenyl)-4-(4-oxiranylmethoxyphen yl) -1-cyclohexene; 20 parts by weight of 1, 5-diaminonaphthalene (manufactured by Wako Pure Chemical Industries, Ltd.), 1107 parts by weight of an alumina powder (α-alumina powder manufactured by Sumitomo Chemical Co., Ltd.; a mixture of 886 parts by weight of alumina having D50 of 10 µm (80% by volume based on the alumina powder), 111 parts by weight of alumina having D50 of 3 µm (10% by volume based on the alumina powder) and 110 parts by weight of alumina having D50 of 0.4 µm (10% by volume based on the alumina powder)) and 300 parts by weight of methyl ethyl ketone were mixed and the resultant mixture was deaerated under vacuum conditions to obtain an epoxy resin composition. The content of the alumina powder based on the total volume of 1-(3-methyl-4-oxiranylmethoxyphenyl)-4-(4-oxiranylmethoxyphen yl)-1-cyclohexene, 1,5-diaminonaphthalene and the alumina powder was calculated assuming that a density of a mixture of 1-(3-methyl-4-oxiranylmethoxyphenyl)-4-(4-axiranylmethoxyphen yl)-1-cyclohexene and 1,5-diaminonaphthalene is 1.2 g/cm³ and a density of the alumina powder is 3.97 g/cm³. As a result, it was 74% by volume.

Using an applicator, the epoxy resin composition was applied on a polyethylene terephthalate base material in a thickness of 400 µm and then dried by standing at room temperature for one hour. After further drying at a temperature of 60°C under a vacuum degree of 1 kPa for 10 minutes, vacuum press molding (press temperature: 140°C, vacuum degree: 1 kPa, press pressure: 4 MPa, treating time: 3.5 minutes) was performed to obtain a prepreg sheet.
After peeling the polyethylene terephthalate film of both surfaces of the resultant prepreg sheet, both surfaces were sandwiched with a copper foil (35 µm) and vacuum-bonded (temperature: 140°C, vacuum degree: 1 kPa, press pressure: 4 MPa, treating time: 10 minutes). Under atmospheric pressure conditions, heating was performed at 140°C for 2 hours, then at 180°C for 3 hours. The resultant sheet was cut into pieces measuring 10 mm × 10 mm and the copper foil was removed to obtain a 200 µm thick resin sheet.

### Comparative Example 1

100 parts by weight of a bisphenol A type epoxy compound, 21 parts by weight of 1,5-diaminonaphthalene (manufactured by Wako Pure Chemical Industries, Ltd.), 1,107 parts by weight of the same alumina powder as that used in Example 1 and 300 parts by weight of methyl ethyl ketone were mixed and the resultant mixture was deaerated under vacuum conditions to obtain a comparative composition. The content of the alumina powder based on the total volume of the bisphenol A type epoxy compound, 1,5-diaminonaphthalene and the alumina mixed powder was calculated assuming that a density of a mixture of the bisphenol A type epoxy compound and 1, 5-diaminonaphthalene is 1.2 g/cm³ and a density of the alumina powder is 3.97 g/cm³. As a result, it was 74% by volume.

Using an applicator, the epoxy resin composition was applied on a polyethylene terephthalate base material in a thickness of 400 µm and then dried by standing at room temperature for one hour. After further drying at a temperature of 60°C under a vacuum degree of 1 kPa for 10 minutes, vacuum press molding (press temperature: 140°C, vacuum degree: 1 kPa, press pressure: 2 MPa, treating time: 3.5 minutes) was performed to obtain a prepreg sheet.

After peeling the polyethylene terephthalate film of both surfaces of the resultant prepreg sheet, both surfaces were sandwiched with a copper foil (35 µm) and vacuum-bonded (temperature: 140°C, vacuum degree: 1 kPa, press pressure: 4 MPa, treating time: 10 minutes). Under atmospheric pressure conditions, heating was performed at 140°C for 2 hours, then at 180°C for 3 hours. The resultant sheet was cut into pieces measuring 10 mm × 10 mm and the copper foil was removed to obtain a 200 µm thick resin sheet. Thermal conductivity of the resultant resin sheet was measured by a xenon flash method, a laser flash method and a temperature wave thermal analytical method. As a result, thermal conductivity measured by the xenon flash method was 3.8 W/m·K and thermal conductivity measured by the temperature wave thermal analytical method was 4.5 W/m·K, while thermal conductivity could not be measured by the laser flash method.

### Industrial Applicability

The epoxy resin composition of the present invention has high thermal conductivity and is therefore useful as insulating materials of printed circuit boards to which high heat dissipation properties are required.

## Claims

1. An epoxy resin composition comprising an epoxy compound represented by the formula (1): 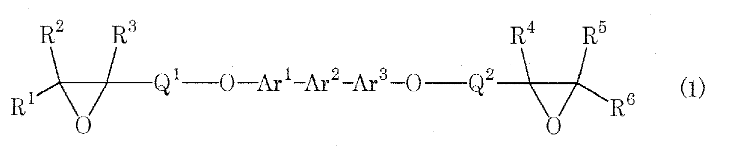 wherein Ar¹, Ar² and Ar³ are the same or different and each denotes any one of divalent groups represented by the following formulas: 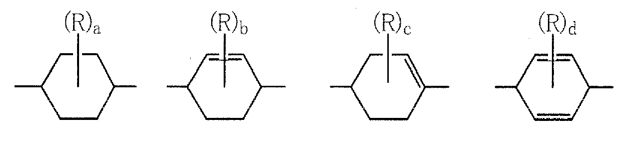 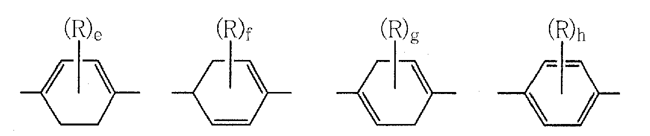 in which R denotes hydrogen atom or an alkyl group having 1 to 18 carbon atoms, a denotes an integer of 1 to 8, b, e and g denote an integer of 1 to 6, c denotes an integer of 1 to 7, d and h denote an integer of 1 to 4, f denotes an integer of 1 to 5, and when more than one R exists in said divalent group, all of R may be the same group or different groups; R¹, R², R³, R⁴, R⁵ and R⁶ are the same or different and each denotes hydrogen atom or an alkyl group having 1 to 18 carbon atoms; Q¹ and Q² are the same or different and each denotes a straight-chain alkylene group having 1 to 9 carbon atoms, in which methylene group composing the straight-chain alkylene group is optionally substituted with an alkyl group having 1 to 18 carbon atoms and -O- or -N(R⁷)- is optionally inserted between the methylene groups, in which R⁷ denotes hydrogen atom or an alkyl group having 1 to 18 carbon atoms; a curing agent and an alumina powder, wherein
the alumnina powder is a mixture of:
an alumina (A) having D50 of 2 µm or more and 100 µm or less,
an alumina (B) having D50 of 1 µm or more and 10 µm or less, and
an alumina (C) having D50 of 0.01 µm or more and 5 µm or less, in which D50 is a particle size at 50% cumulation from the smallest particle side of a weight cumulative particle size distribution, and
the content of the alumina (A), that of the alumina (B) and that of the alumina (C) are respectively 50% by volume or more and 90% by volume or less, 5% by volume or more and 40% by volume or less, and 1% by volume or more and 30% by volume or less, based on the volume of the alumina powder (provided that the total % by volume of the alumina (A), the alumina (B) and the alumina (C) is 100% by volume).

2. The epoxy resin composition according to claim 1, wherein the alumina powder is a α-alumina powder.

3. The epoxy resin composition according to claim 1 or 2,
wherein the epoxy compound represented by the formula (1) is an epoxy compound represented by the formula (2): 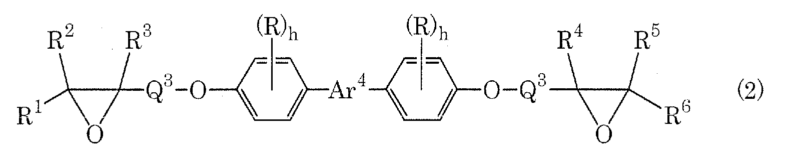 wherein Ar⁴ denotes any one of divalent groups represented by the following formulas: 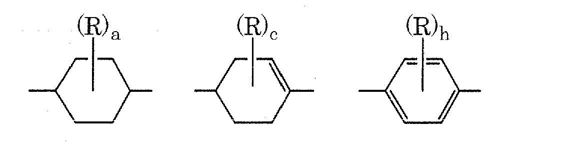 R, R¹, R², R³, R⁴, R⁵, R⁶, a, c and h are as defined above; Q³ denotes any one of groups represented by the following formulas:
-(CH₂)ₘ- -(CH₂)ₚ-Q-(CH₂)_{q}-
m denotes an integer of 1 to 9; p and q each denotes an integer of 1 to 8 and the sum of p and q is 9 or less, in which methylene group composing the group denoted by Q³ is optionally substituted with an alkyl group having 1 to 18 carbon atoms.

4. The epoxy resin composition according to claim 3, wherein R¹, R², R³, R⁴, R³ and R⁶ in the formula (2) denote hydrogen atom.

5. The epoxy resin composition according to claim 3, wherein the epoxy compound represented by the formula (2) is an epoxy compound represented by the formula (3): 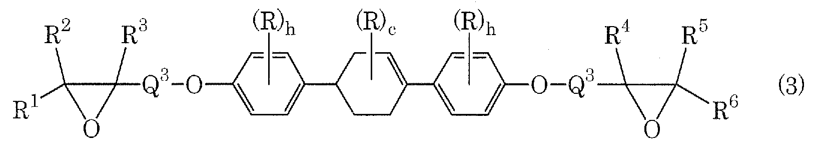 wherein R, R¹, R², R³, R⁴, R⁵, R⁶, a, c and h are as defined above; Q³ denotes a group represented by the following formula:
-(CH₂)ₘ-
and m denotes an integer of 1 to 9.

6. The epoxy resin composition according to claim 5, wherein R¹, R², R³, R⁴, R⁵ and R⁶ in the formula (3) denote hydrogen atom.

7. The epoxy resin composition according to claim 5, wherein the epoxy compound represented by the formula (3) is an epoxy compound represented by the formula (4): 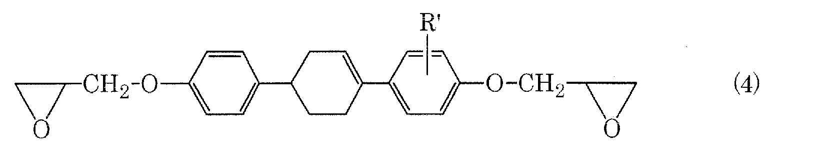 wherein R' denotes hydrogen atom or an alkyl group having 1 to 4 carbon atoms.

8. The epoxy resin composition according to claim 1, wherein the curing agent is an amine type curing agent, a resorcin novolak type curing agent, a phenol novolak type curing agent or an acid anhydride type curing agent.

9. The epoxy resin composition according to claim 1, wherein the curing agent is an amine type curing agent.

10. The epoxy resin composition according to claim 9, wherein the amine type curing agent is 4,4'-diaminodiphenylmethane, 4,4'-diaminodiphenylethane; 1,5-diaminonaphthalene or p-phenylenediamine.

11. The epoxy resin composition according to claim 1, further containing an inorganic fiber which contains alumina as a main component and has a number-average fiber diameter of 1 to 50 µm.

12. A cured epoxy resin obtained by curing the epoxy resin composition according to any one of claims 1 to 11.
